(19) Europäisches Patentamt
European Patent Office
Office européen des brevets

(11) EP 1 862 854 A1

(12) **EUROPEAN PATENT APPLICATION**

(43) Date of publication:
**05.12.2007 Bulletin 2007/49**

(51) Int Cl.:
***G03F 7/004*** *(2006.01)* ***G03F 7/039*** *(2006.01)*

(21) Application number: **07107637.6**

(22) Date of filing: **07.05.2007**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK YU**

(30) Priority: **29.05.2006 JP 2006148173**

(71) Applicant: **TOKYO OHKA KOGYO CO., LTD.**
**Kawasaki-shi, Kanagawa-ken (JP)**

(72) Inventors:
- **SHIONO, Daiju**
**Tokyo Ohka Kogyo Co., Ltd.**
**Kawasaki-shi, Kanagawa-ken (JP)**
- **HADA, Hideo**
**Tokyo Ohka Kogyo Co., Ltd.**
**Kawasaki-shi, Kanagawa-ken (JP)**

(74) Representative: **Portal, Gérard et al**
**Cabinet Beau de Loménie**
**158, rue de l'Université**
**75340 Paris Cédex 07 (FR)**

(54) **Decomposable composition and method for using the same**

(57) A decomposable composition including a compound (I) represented by general formula (I) shown below and a compound (II) represented by general formula (II) shown below:

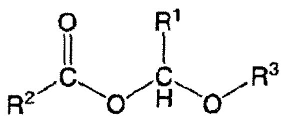 ··· ( I )

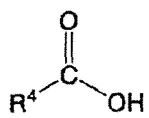 ··· ( I I )

[wherein $R^1$ represents a hydrogen atom, a halogen atom, an alkyl group or a halogenated alkyl group; and $R^2$, $R^3$ and $R^4$ each independently represents a monovalent organic group.]

EP 1 862 854 A1

## Description

TECHNICAL FIELD

The present invention relates to a decomposable composition and a method for using the same.
Priority is claimed on Japanese Patent Application No. 2006-148173, filed May 29, 2006, the content of which is incorporated herein by reference.

BACKGROUND ART

Lithography techniques are widely used in the production of microscopic structures that are used in a variety of electronic devices such as semiconductor devices and liquid crystal devices.
Conventionally, in lithography techniques, photosensitive organic materials known as photoresists have been used. A photoresist typically used displays a changed solubility to an alkali developing solution (alkali solubility) by irradiation (exposure) of radial rays such as short-wavelength light (e.g., vacuum ultraviolet) or electron beam. The photoresist displays changes in alkali solubility by decomposition of a part of the structure thereof or a formation of a cross-linking structure which occurs upon exposure.
As a result, difference in alkali solubility is caused between an exposed portion and an unexposed portion, thus enabling the formation of a resist pattern. Namely, by conducting selective exposure of a photoresist, the alkali solubility of the photoresist is partially changed, so that the photoresist has a pattern which includes a portion displaying high alkali solubility and a portion displaying low alkali solubility.
Further, by alkali developing the thus exposed photoresist, the portion displaying high alkali solubility is dissolved and removed, thereby forming a resist pattern.
Photoresists include positive resists which display increased alkali solubility at an exposed portion, and negative resists which display reduced alkali solubility at an exposed portion.
In recent years, in the production of semiconductor elements and liquid crystal display elements, advances in lithography techniques have led to rapid progress in the field of miniaturization. Typically, these miniaturization techniques involve shortening the wavelength of the exposure light source. Therefore, photoresists are required to exhibit high sensitivity (photosensitivity) to an exposure light source.
As a photoresist exhibiting high sensitivity to an exposure light source of short-wavelength light, a chemically amplified positive resist composition is known which includes an acid generator which generates acid on exposure and a base component which displays changed alkali solubility by action of the acid.
Presently, as a base component for a chemically amplified positive resist composition, a resin (base resin) is typically used in which alkali-soluble groups such as hydroxyl groups or carboxyl groups are protected with acid dissociable, dissolution inhibiting groups which dissociate by action of acid generated from the acid generator.
In a chemically amplified positive resist composition, when acid is generated from the acid generator on exposure, the acid dissociable, dissolution inhibiting groups of the base resin dissociate to increase alkali solubility, and as a result, the entire positive resist composition displays increased alkali solubility.
Presently, as a base resin, a polyhydroxy styrene resin or a resin having a structural unit derived from (meth)acrylate ester (acrylic resin) is typically used (for example, see Patent Documents 1 and 2). Here, the term "(meth)acrylate ester" is a generic term that includes either or both of the acrylate ester having a hydrogen atom bonded to the $\alpha$-position and the methacrylate ester having a methyl group bonded to the $\alpha$-position. The term "(meth)acrylate" is a generic term that includes either or both of the acrylate having a hydrogen atom bonded to the $\alpha$-position and the methacrylate having a methyl group bonded to the $\alpha$-position.
As an acid generator, various types have been proposed, such as onium salt-based acid generators including sulfonate-based acid generators and iodonium-based acid generators, oxime sulfonate-based acid generators, and imide sulfonate-based acid generators. Among these, onium salt-based acid generators, especially sulfonium salt-based acid generators are most typically used, as they exhibit excellent sensitivity.
Until now, various proposals have been made for improving the sensitivity of a resist. For example, Non-Patent Document 1 proposes a method in which an acetoacetate ester having a (sulfonyloxy)methyl group is used for improving the sensitivity of a chemically amplified resist composiiton. In this method, profileration of acid is accelerated in a chemically amplified resist composition, so as to improve the sensitivity of the resist cmposition. Specifically, the acetoacetate ester is decomposed in the chemically amplified resist compostion by the action of acid generated from a sulfonium salt-based acid generator, to generate a sulfonic acid. For example, from tert-butyl 2-methyl-2-((p-toluenesulfonyloxy)methyl) acetoacetate, p-toluenesulfonic acid is generated. Then, the sulfonic acid generated from the acetoacetate ester, like the acid generated from the acid generator, dissociates the acid dissociable, dissolution inhibiting groups of the base resin. Further, the acetoacetate ester is decomposed by the sulfonic acid generated therefrom, thereby proliferating acid.
Recently, in addition to the above-mentioned lithography techniques using a photoresist, various techniques

have been studied, such as thermal lithography which uses heat instead of radiation (for example, see Non-Patent Documents 2 and 3).

[Patent Document 1] Japanese Patent No. 2,881,969
[Patent Document 2] Japanese Unexamined Patent Application, First Publication No. 2003-241385
[Non-Patent Document 1] J. Am. Chem. Soc. 1998, Vol. 120, pp.37-45
[Non-Patent Document 2] Jpn. J. Appl. Phys. Vol. 43, No. 8B (2004) pp. L1045-L1047
[Non-Patent Document 3] Jpn. J. Appl. Phys. Vol. 41, No. 9A/B (2002) pp. L1022-L1024

DISCLOSURE OF INVENTION

PROBLEMS TO BESOLVED BY THE INVENTION

In such a new technique, development of a novel material for use in the technique becomes important. For example, in thermal lithography, it is considered that a material is required which exhibits changed properties (such as alkali solubility) under the action of heat.
The present invention addresses the circumstances described above, with an object of providing a novel decomposable composition and a method for using the same.

MEANS FOR SOLVING THE PROBLEMS

In order to achieve the above-mentioned object, the present invention employs the aspects described below.
A first aspect of the present invention is a decomposable composition including a compound (I) represented by general formula (I) shown below and a compound (II) represented by general formula (II) shown below:
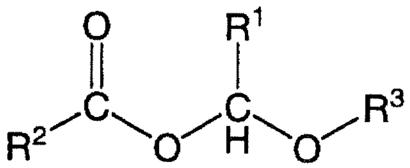 ··· (I)

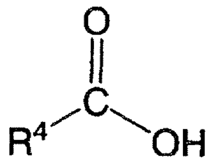 ··· (II)

[wherein $R^1$ represents a hydrogen atom, a halogen atom, an alkyl group or a halogenated alkyl group; and $R^2$, $R^3$ and $R^4$ each independently represents a monovalent organic group.]
A second aspect of the present invention is a method for using a decomposable composition of a first aspect of the present invention, including the steps of:

forming a film on a substrate by using a decomposable composition of a first aspect of the present invention;
reacting the compound (I) with the compound (II) in the film to form a compound (III) represented by general formula (III) shown below from the compound (I); and
decomposing the compound (I) with the compound (III):

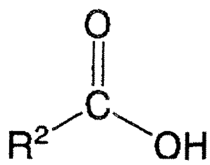 ··· (III)

[wherein $R^2$ is as defined for $R^2$ in general formula (I) above.]

EFFECT OF THE INVENTION

By the present invention, there is provided a novel decomposable composition and a method for using the same.

BEST MODE FOR CARRYING OUT THE INVENTION

«Decomposable composition»

The decomposable composition of the present invention includes a compound (I) represented by general formula (I) shown above and a compound (II) represented by general formula (II) shown above.
In the decomposable composition, decomposition of the compound (I) proceeds, regardless of whether or not the decomposable composition contains any other components.
More specifically, the compound (I) is an ester of a carboxylic acid ($R^2$-COOH), and has a structure in which the hydrogen atom within a carboxyl group $R^2$-COOH is replaced by -CH($R^1$)-O$R^3$. By including -CO-O- CH($R^1$)-O in the structure, the compound (I) is decomposable even by action of a relatively weak acid such as a carboxylic acid (the compound (II)). When one molecule of the compound (I) decomposes, at least two decomposition products including a compound (III) represented by general formula (III) shown below are formed. That is, in the compound (I), when the compound (II) acts on the compound (I), at least the linkage between the oxygen atom bonded to the carbon atom within the carbonyl group adjacent to $R^2$ and the carbon atom to which the oxygen atom is bonded (i.e., carbon atom having $R^1$ bonded thereto) is broken to form a compound (III).
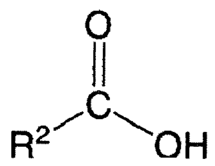

··· (III)

[wherein $R^2$ is as defined for $R^2$ in general formula (I) above.]
This compound (III), like the compound (II), acts on compound (I) to decompose it. By the formation of the compound (III), decomposition efficiency of the compound (I) is improved.
More specifically, in the decomposable composition, firstly, when the decomposition of the compound (I) is started by the compound (II), the compound (III) is formed, and the compound (III), like the compound (II), decomposes the compound (I). As the decomposition of the compound (I) proceeds and the amount of the compound (I) decreases, the amount of carboxylic acids in the decomposable composition (i.e., the compounds (II) and (III)) increases. As a result, the decomposition efficiency of the compound (I) is improved.
Further, by the decomposition, the molecular weight of the compound (I) becomes smaller simultaneously with the formation of decomposition products such as $R^2$-COOH, so that the properties of the decomposable composition change (e.g., increase in alkali solubility and lowering of hydrophobicity). For example, as in the method for using the decomposable composition of the present invention described below, the decomposable composition may be used to form a film, and the compound (I) is reacted with the compound (II) by subjecting a part or all of the film to heating or the like to decompose the compound (I), thereby changing the properties of the film.

<Compound (I)>

The compound (I) is a compound represented by general formula (I) shown above.
In general formula (I), $R^1$ represents a hydrogen atom, a halogen atom, an alkyl group or a halogenated alkyl group.
Examples of halogen atoms include a fluorine atom, a chlorine atom, a bromine atom and an iodine atom, and a fluorine atom is particularly preferred.
As an alkyl group for $R^1$, there is no particular restriction, and examples thereof include straight-chain, branched or cyclic alkyl groups of 1 to 10 carbon atoms. As an alkyl group, a straight-chain or branched lower alkyl group of 1 to 5 carbon atoms or a cyclic alkyl group of 5 or 6 carbon atoms is preferable. Examples of straight-chain or branched lower alkyl groups include a methyl group, an ethyl group, a propyl group, an isopropyl group, an n-butyl group, an isobutyl group,

a tert-butyl group, a pentyl group, an isopentyl group and a neopentyl group. Examples of cyclic alkyl groups include a cyclohexyl group and a cyclopentyl group.
Examples of halogenated alkyl groups include the above-exemplfied alkyl groups in which some or all of the hydorgen atoms are substituted with halogen atoms.
As $R^1$, a hydrogen atom is particularly desirable.
$R^2$ and $R^3$ each independently represents a monovalent organic group, and the organic groups of $R^2$ and $R^3$ may be the same or different.
Here, the term "organic group" refers to a group containing carbon atom(s).
Basically, as the organic group, a group containing carbon and hydrogen as the main component elements is preferable. Examples of such groups include a hydrocarbon group; a hydrocarbon group in which some or all of the hydrogen atoms thereof are substituted with substituents; and a hydrocarbon group in which some of the carbon atoms are substituted with an atom or group other than a carbon atom or hydrogen atom.
The hydrocarbon group may be a chain-like hydrocarbon group, a cyclic hydrocarbon group, or a group including a chain-like hydrocarbon group and a cyclic hydrocarbon group.
As a substituent, there is no particular restriction as long as it is an atom or group other than a carbon atom or hydrogen atom, and examples thereof include a halogen atom, an oxygen atom (=0), a carboxyl group, a hydroxyl group or a cyano group.
Examples of an atom or group other than a carbon atom or hydrogen atom, which substitutes some of the carbon atoms of a hydrocarbon group include an oxygen atom (-O-).
Specific examples of organic groups as $R^2$ include a group obtained by removing one carboxyl group or carboxylic acid ester group (i.e., a group in which the hydrogen atom of the carboxyl group is replaced by an organic group) from a compound having at least one carboxyl group and/or carboxylic acid ester group.
Examples of such a compound include the following two types:

(1) a polymer having a carboxyl group and/or carboxylic acid ester group, and
(2) a non-polymer having a carboxyl group and/or carboxylic acid ester.

Here, the term "polymer" refers to a compound (resin) obtained by polymerizing two or more molecules of at least one monomer, and is constituted from a plurality of recurring units (structural units). On the other hand, the term "non-polymer" means a compound which is not a polymer.
As the polymer of item (1) above, for example, any resins having a carboxyl group and/or carboxylic acid ester group can be used among resins proposed as base resins for a chemically amplified resist composition. Examples of such resins include acrylic resins having a structural unit derived from (meth)acrylic acid ester.
As the non-polymer of item (2) above, for example, amongst compounds generally known as organic acids, those having a carboxyl group may be exemplified. Examples of such organic acids include carboxylic acids, hydroxylic acids, and esters of these acids.
In the present invention, of these, an organic group as $R^2$ is preferably a group obtained by removing one carboxyl group or carboxylic ester group from the non-polymer of item (2) above, and a group having a cyclic group is particularly desirable. Examples of groups having a cyclic group include the same groups as those exemplified below as $R^7$ and $R^8$ in general formula (I-1) shown below.
The organic group as $R^3$ can be broadly classified into the following two categories:

(1') a group having a structure including one or more of -CO-O-CH(-R)-O-[wherein R, like $R^1$ above, represents a hydrogen atom, a halogen atom, an alkyl group or a halogenated alkyl group] (hereafter, this structure is frequently referred to as "acetal structure"), and
(2') a group which does not have an acetal structure.

The compound (I) has a structure in which the carbon atom of the carboxy group within the acetal structure is bonded to $R^2$. As mentioned above, in the decomposition of the compound (I), at least the linkage between the oxygen atom bonded to the carbon atom within the carbonyl group adjacent to $R^2$ and the carbon atom to which the oxygen atom is bonded (i.e., carbon atom having $R^1$ bonded thereto) is broken.
Therefore, when the organic group as $R^3$ has a group of item (1') above (i.e., when the compound (I) has a plurality of acetal structures), in the acetal structure within the group of item (1') above, breakage of a linkage occurs in a similar manner as in the acetal structure having $R^2$ bonded thereto. As a result, the compound (I) within the decomposable composition is decomposed into at least <the number of all acetal structures within the compound (I) + 1>.
As the group of item (1') above, for example, a group represented by the following general formula (IV) may be exemplified.
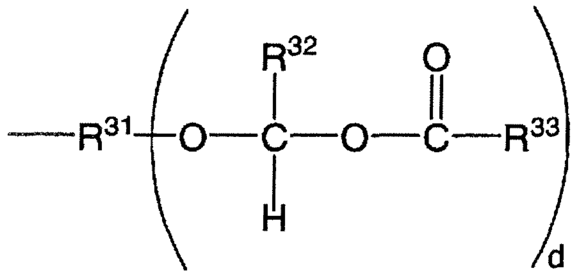

... (IV)

In formula (IV) above, d is an integer of 1 to 3, preferably 1 or 2, most preferably 1. $R^{31}$ represents an organic group having a valency of (d + 1); $R^{32}$ represents a hydrogen atom, a halogen atom, an alkyl group or a halogenated alkyl group; and $R^{33}$ represents a monovalent organic group.
Examples of $R^{31}$ include the same groups as those exemplified below as organic groups having a valency of (d+1) as $R^9$ in general formula (I-1) shown below.
Examples of $R^{32}$ include the same groups as those exemplified as $R^1$ in formula (I) above.
Examples of $R^{33}$ include the same groups as those exemplified above as organic groups as $R^2$ in formula (I) above.

As the group of item (2') above, for example, a lower alkyl group, an alicyclic group or the like may be exemplified. A lower alkyl group is an alkyl group of 1 to 5 carbon atoms, and may be straight-chain, branched or cyclic. Specific examples of lower alkyl groups include a methyl group, ethyl group, propyl group, isopropyl group, n-butyl group, isobutyl group, tert-butyl group, pentyl group, isopentyl group or neopentyl group.
In the present description and claims, the term "aliphatic" is a relative concept used in relation to the term "aromatic", and defines a group or compound that has no aromaticity.
Further, the term "aliphatic cyclic group" refers to a monocyclic group or polycyclic group that has no aromaticity.
Furthermore, the aliphatic cyclic group may be either saturated or unsaturated, but is preferably saturated.
Examples of aliphatic cyclic groups include aliphatic monocyclic groups of 5 to 8 carbon atoms and aliphatic polycyclic groups of 6 to 16 carbon atoms. As aliphatic monocyclic groups of 5 to 8 carbon atoms, groups in which one or more hydrogen atoms have been removed from a monocycloalkane may be exemplified. Specific examples of such aliphatic monocyclic groups include groups in which one or more hydrogen atoms have been removed from cyclopentane or cyclohexane. As aliphatic polycyclic groups of 6 to 16 carbon atoms, groups in which one or more hydrogen atoms have been removed from a bicycloalkane, tricycloalkane or tetracycloalkane may be exemplified. Specific examples of such aliphatic polycyclic groups include groups in which one or more hydrogen atoms have been removed from a polycycloalkane such as adamantane, norbornane, isobornane, tricyclodecane or tetracyclododecane. Of these, aliphatic polycyclic groups are preferable, and from an industrial viewpoint, an adamantyl group, norbonyl group or tetracyclodecanyl group is preferable, although an adamantyl group is particularly desirable.
An aliphatic cyclic group may or may not have a substituent. Examples of substitutents include lower alkyl groups of 1 to 5 carbon atoms, a fluorine atom, fluorinated lower alkyl groups of 1 to 5 carbon atoms, and an oxygen atom (=O). An aliphatic cyclic group preferably has, as a substituent, a lower alkyl group of 1 to 5 carbon atoms, although a methyl group is particularly desirable.
An aliphatic cyclic group may be a hydrocarbon group (alicyclic group) in which the basic ring exclusive of substituents is constituted from only carbon and hydrogen, or a heterocyclic group in which some of the carbon atoms consituting the ring of the alicyclic group are replaced by hetero atoms (e.g., oxygen atom or nitrogen atom). The aliphatic cyclic group is preferably an alicyclic group.
As specifc examples of aliphatic cyclic groups within the group of item (2') above, those represented by chemical formulas shown below may be exemplified.

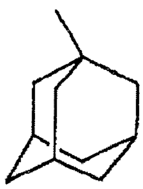
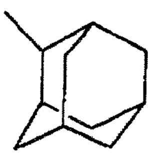
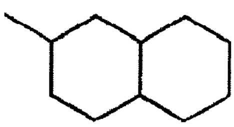
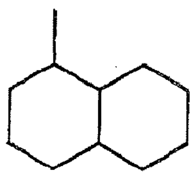
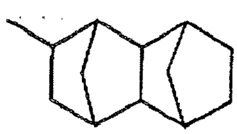

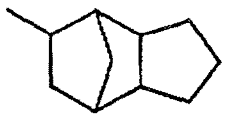 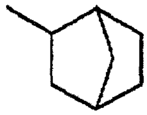 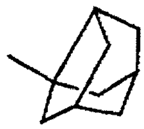 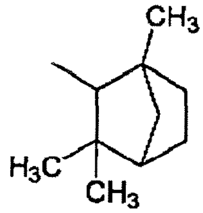 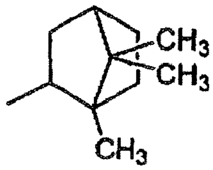

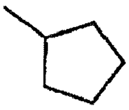 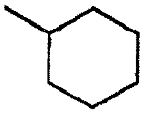 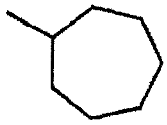 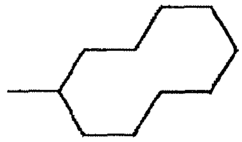 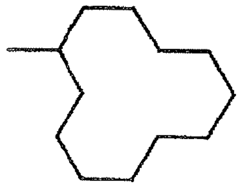

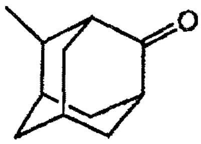 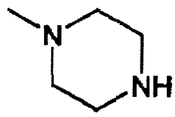

In the present invention, the compound (I) is preferably a non-polymer having a molecular weight of 5,00 to 3,000. The molecular weight of the compound (I) is more preferably 500 to 2,500, still more preferably 500 to 2,000, most preferably 500 to 1,600. When the compound (I) has a molecular weight of 500 or more, the compound (I) is advantageous in that it exhibits good film formability. On the other hand, when the compound (I) has a molecular weight of 3,000 or less, dissolution contrast is improved.
As mentioned above, one molecule of a compound (I) is decomposed into two molecules by the action of the compound (II). When the compound (I) is a non-polymer, it is preferable that the compound (I) form, as decomposition products, two or more molecules of decomposition products having a molecular weight of 200 or more. The upper limit of the molecular weight of the decomposition product depends on the molecular weight of the compound (I). However, the molecular weight of the decomposition product is preferably 1,000 or less, more preferably 900 or less. When the molecular weight of the decomposition product is 1,000 or less, the effect of the present invention becomes satisfactory. It is particularly desirable that the number of decomposition products formed be 2 to 4.
Further, when the compound (I) is a non-polymer, the compound (I) is preferably a material capable of forming an amorphous film. By using such a material as the compound (I), it becomes possible to form a film using the decomposable composition of the present invention, so that the decomposable composition can be preferably applied to the method for using the same according to the present invention described below.
In this description, an amorphous film refers to an optically transparent film that does not crystallize. Spin-coating is one of the most commonly used techniques for forming thin films, and an evaluation as to whether or not the material as the compound (I) is capable of forming an amorphous film using spin-coating is determined on the basis of whether or not a film formed by spin-coating onto an 8-inch silicon wafer is transparent over the entire film surface.
More specifically, the evaluation can be conducted, for example, in the manner described below. First, the material as the compound (I) is added to a solvent typically used as a resist solvent. For example, 100 parts by weight of compound (I) is dissolved in an organic solvent containing 1,570 parts by weight of propylene glycol monomethyl ether acetate, and dissolution is performed by ultrasound treatment (dissolution treatment) using an ultrasound cleaning apparatus. Then, the resultant solution is spin-coated onto a wafer at 1,500 rpm and subjected to drying and baking (PAB: Post Applied Bake) at 110°C for 90 seconds. A visual assessment as to whether the formed film is transparent is then used to confirm whether or not an amorphous film has been formed. A non-transparent, cloudy film is not an amorphous film
In the present invention, the compound (I) preferably exhibits favorable stability for the amorphous film formed in the manner described above, and compounds for which the amorphous state is retained even after standing for 2 weeks at room temperature following the above PAB treatment are particularly desirable.
Specific examples of the compound (I) include compounds represented by general formula (I-1) shown below (hereafter, these compounds are referred to as compounds (I-1)):
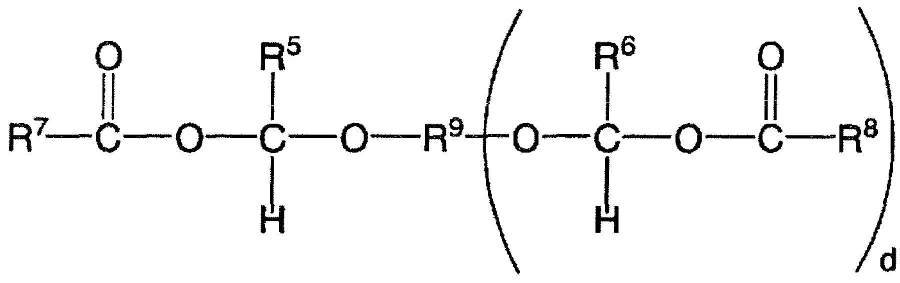

... (I - 1)

[wherein $R^5$ and $R^6$ each independently represents a hydrogen atom, a halogen atom, an alkyl group or a halogenated alkyl group; $R^7$ and $R^8$ each independently represents a cyclic group-containing group; $R^9$ represents an organic group having a valency of (d + 1); and d represents an integer of 1 to 3.]

In the compound (I-1), by the action of the compound (II), the linkage between the oxygen atom bonded to the carbon atom within the carbonyl group adjacent to $R^7$ and/or $R^8$ and the carbon atom to which the oxygen atom is bonded (i.e., carbon atom having $R^5$ and/or $R^6$ bonded thereto) is broken, and the compound (I-1) is decomposed. By the decomposition of the compound (I-1), the molecular weight of the compound (I-1) is decreased, and simultaneously, carboxylic acids such as $R^7$-COOH and $R^8$-COOH are formed as decomposition products.

As the decomposition products, it is presumed that (d +1) carboxylic acids (one $R^7$-COOH and d $R^8$-COOHs) formed by decomposition of the terminal portions and one compound derived from the central portion (i.e., portion including $R^9$ and the remainder) of the compound (I-1) are formed.

In the present invention, it is preferable that two or more of these decomposition products have a molecular weight of 200 or more, and it is particularly desirable that all of the carboxylic acids formed have a molecular weight of 200 or more.

In general formula (I-1) above, $R^5$ and $R^6$ each independently represents a hydrogen atom, a halogen atom, an alkyl group or a halogenated alkyl group.

As the halogen atom, alkyl group and halogenated alkyl group as $R^5$ and $R^6$, those exemplified above as $R^1$ in general formula (I) may be exemplified.

As $R^5$ and $R^6$, a hydrogen atom is particularly desirable.

$R^7$ and $R^8$ each independently represents a cyclic group-containing group.

The cyclic group within $R^7$and $R^8$may be an aromatic cyclic group or an aliphatic cyclic group, and an aliphatic cyclic group is preferable.

The cyclic group may or may not have a substituent. Examples of substituents include lower alkyl groups of 1 to 5 carbon atoms, a fluorine atom, fluorinated lower alkyl groups of 1 to 5 carbon atoms, an oxygen atom (=O) and a hydroxyl group.

In the present description and the claims, the term "aromatic cyclic group" describes a monocyclic group or polycyclic group that has aromaticity.

Specific examples of aromatic monocyclic groups include groups in which one or more hydrogen aroms have been removed from a benzene ring which may or may not have a substituent.

Specific examples of aromatic polycyclic groups include aromatic polycyclic groups of 10 to 16 carbon atoms which may or which may not have a substituent. Examples of aromatic polycyclic groups of 10 to 16 carbon atoms include groups in which one or more hydrogen atoms have been removed from naphthalene, anthracene, phenanthrene or pyrene. Specific examples include a 1-naphthyl group, 2-naphthyl group, 1-anthracenyl group, 2-anthracenyl group, 1-phenanthryl group, 2-phenanthryl group, 3-phenanthryl group or 1-pyrenyl group.

As mentioned above, the term "aliphatic cyclic group" describes a monocyclic group or polycyclic group that has no aromaticity.

With respect to the aliphatic cyclic group within $R^7$ and $R^8$, the constitution of the basic ring exclusive of substituents is not limited to groups constituted from only carbon and hydrogen (i.e., hydrocabon groups), but the basic ring is preferably a hydorcarbon group. Further, the hydrocabon group may be saturated or unsaturated, although in general, the hydrocarbon group is preferably saturated.

Examples of aliphatic monocyclic groups include aliphatic monocyclic groups of 4 to 15 carbon atoms which may or may not have a substitutent. Specific examples include groups in which one or more hydrogen atoms have been removed from a monocycloalkane such as cyclopentane or cyclohexane.

Examples of aliphatic polycyclic groups include groups in which one or more hydrogen atoms have been removed from a bicycloalkane, tricycloalkane or tetracycloalkane, which may be or may not be substituted. Specific examples of such aliphatic polycyclic groups include groups in which one or more hydrogen atoms have been removed from a polycycloalkane such as adamantane, norbornane, isobornane, tricyclodecane, tetracyclododecane or perhydrocyclopentaphenanthrene.

With respect to $R^7$ and $R^8$, it is preferable that decomposition products containing $R^7$ or $R^8$ formed by the decompostion of the compound (I-1) have a molecular weight of 200 or more. In other words, it is preferable that, when $R^7$-COOH and/or $R^8$-COOH are formed by the decomposition of the compound (I-1), $R^7$-COOH and/or $R^8$-COOH have a molecular weight of 200 or more.

As $R^7$ and $R^8$, groups containing a polycyclic group or groups containing two or more cyclic groups having at least one monocyclic group are preferred.

The polycyclic group for a "group containing a polycyclic group" may be an aromatic polycyclic group or an aliphatic polycyclic group.

The "group containing a polycyclic group" may be a polycyclic group itself which is exemplified above, or a group containing the polycyclic group as a substituent.

Examples of groups containing a polycyclic group as a substituent include groups in which a hydrogen atom of a straight-chain or branched alkyl group is substituted with a polycyclic group. The chain-like or branched alkyl group is preferably an alkyl group of 1 to 10 carbon atoms, more preferably an alkyl group of 1 to 8 carbon atoms, most preferably 1 to 5 carbon atoms.

In the present invention, it is particularly desirable that each of $R^7$and $R^8$ be a group having a perhydrocyclopentaphenanthrene ring as a basic skeleton, as the compound (I) exhibits excellent decomposability.

As shown by the formula below, a perhydrocyclopentaphenanthrene ring is a condensed polycyclic hydrocarbon including three 6-membered rings and one 5-membered ring, and is known to constitute a basic skeleton of a steroid such as bile acid or cholesterol.

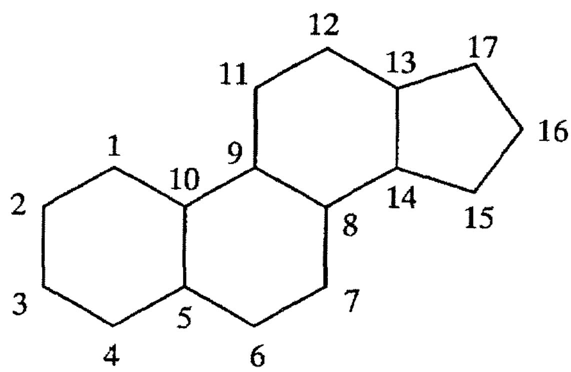

The perhydrocyclopentaphenanthrene ring may have a substituent such as a lower alkyl group of 1 to 5 carbon atoms, a fluorine atom, a fluorinated lower alkyl group of 1 to 5 carbon atoms, an oxygen atom (=0) or a hydroxyl group. From the viewpoint of industrial availability, it is particularly desirable that the perhydrocyclopentaphenanthrene ring have a methyl group and/or a hydroxyl group.

As $R^7$ and $R^8$, the group having a perhydrocyclopentaphenanthrene ring as a basic skeleton is preferably a group in which a carboxyl group has been removed from a monocarboxylic acid such as cholanoic acid or cholanoic acid having a substituent such as a hydroxyl group or oxygen atom (=O) bonded to the ring structure. From the viewpoint of industrial availability of raw materials, groups in which a carboxyl group has been removed from at least one monocarboxylic acid selected from cholanoic acid, lithocholic acid, deoxycholic acid, cholic acid, $\alpha$-hyodeoxycholanic acid and dehydrocholic acid are particularly desirable.

With respect to a "group containing two or more cyclic groups having at least one monocyclic group" as $R^7$ and/or $R^8$, the monocyclic group may be an aromatic monocyclic group or an aliphatic monocyclic group, although an aromatic monocyclic group is preferable, and a group in which one or more hydrogen atoms have been removed from benzene is particularly desirable.

The monocyclic group may or may not have a substituent. Examples of substituents include aryl groups of 6 to 14 carbon atoms, lower alkyl groups of 1 to 5 carbon atoms, a fluorine atom, fluorinated lower alkyl groups of 1 to 5 carbon atoms, an oxygen atom (=O) and a hydroxyl group. From the viewpoint of industrial availability, it is particularly desirable that the monocyclic group have a methyl group and/or a hydroxyl group.

The group containing two or more cyclic groups having at least one monocyclic group may contain a polycyclic group. Examples of polycyclic groups include those exemplified above.

In the present invention, as the group containing two or more cyclic groups having at least one monocyclic group as $R^7$ and $R^8$, a group containing two or more aromatic monocyclic groups is preferable, and a group containing three aromatic monocyclic groups is particularly desirable.

Among groups containing three aromatic monocyclic groups, those which have a triphenylmethane structure in which hydrogen atoms of methane have been substituted with three phenyl groups are preferred. In such groups, the phenyl groups may have substituents such as lower alkyl groups and hydroxyl groups.

$R^7$ and $R^8$ may be the same or different. From the viewpoint of ease in synthesizing, $R^7$ and $R^8$ are preferably the same.

d represents an integer of 1 to 3, preferably 1 or 2, most preferably 1.
When d is an integer of 2 or more, namely, when the compound (I) has two or more groups represented by the formula: $-O-CH(R^6)-O-CO-R^8$, these groups may be the same or different.

$R^9$ is an organic group having a valency of (d+1).
As $R^9$, the organic group is preferably a saturated hydrocarbon group.
The saturated hydrocarbon group may be straight-chain, branched or cyclic. Here, a cyclic, saturated hydrocarbon group refers to all hydrocarbon groups having a cyclic structure, including cyclic groups in which (d + 1) hydrogen atoms have been removed from a hydrocarbon group, and such cyclic groups having a straight-chain or branched alkylene group bonded thereto.
The saturated hydrocarbon group preferably has 1 to 15 carbon atoms, more preferably 1 to 10 carbon atoms, still more preferably 1 to 8 carbon atoms.
The saturated hydrocarbon group may or may not have a substituent. There is no particular limitation to the substituent, and examples thereof include a halogen atom such as a fluorine atom, chlorine atom, bromine atom, or iodine atom, and chain-like or cyclic alkyl groups of 1 to 6 carbon atoms. Here, the expression "have a substituent" means that some or all of the hydrogen atoms of the saturated hydrocarbon group have been substituted with a substituent.
Further examples of organic groups as $R^9$ include the above-mentioned groups in which some of the carbon atoms of the hydrocarbon group have been replaced by a hetero atom such as an oxygen atom, nitrogen atom or sulfur atom.

As $R^9$, a divalent or trivalent saturated hydrocarbon group is preferable, and a divalent saturated hydrocarbon group (i.e., alkylene group) is particularly desirable.
Examples of chain-like or branched, trivalent saturated hydrocarbon groups include groups in which three hydrogen atoms have been removed from methane, ethane, propane, butane, pentane, hexane, heptane, octane, and the like.
Examples of cyclic, trivalent saturated hydrocarbon groups include cyclic groups in which 3 hydrogen atoms have been removed from a cyclic saturated hydrocarbon such as cyclopentane, cyclohexane, cycloheptane, norbornane, isobornane, adamantane, tricyclodecane and tetracyclododecane; and such cyclic groups having a chain-like or branched alkylene group bonded thereto.
Examples of straight-chain or branched alkylene groups include a methylene group, ethylene group, propylene group, isopropylene group, n-butylene group, isobutylene group, tert-butylene group, pentylene group, isopentylene group and neopentylene group.
Examples of cyclic alkylene groups include groups in which two hydrogen atoms have been removed from a cyclic saturated hydrocarbon such as cyclopentane, cyclohexane, norbornane, isobornane, adamantane, tricyclodecane or tetracyclododecane; and such cyclic groups having a straight-chain or branched alkylene group bonded thereto.

As $R^9$, a straight-chain alkylene group or cyclic alkylene group is preferable.
As a straight-chain alkylene group, an alkylene group of 1 to 5 carbon atoms is preferable, and a ethylene group or propylene group is particularly desirable.
As a cyclic alkylene group, a group in which a straight-chain or branched alkylene group is bonded to a cyclic group is preferable, and a group represented by general formula (x1) shown below is particularly desirable.

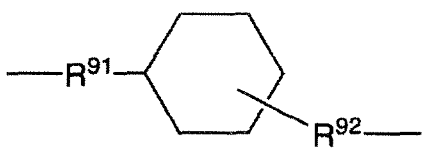

··· (x 1)

In formula (x1), $R^{91}$ and $R^{92}$ each independently represents a straight chain or branched alkylene group of 1 to 5 carbon atoms, and the number of carbon atoms of the alkylene group is preferably 1 to 4, more preferably 1 to 3, most preferably 1.
In formula (x1), it is particularly desirable that $R^{92}$ be bonded to the para position of $R^{91}$.

The compound (I-1) can be synthesized, for example, by dissolving a monocarboxylic acid having a polycyclic group (e.g., cholanoic acid, lithocholic acid, deoxycholic acid, cholic acid, $\alpha$-hyodeoxycholanic acid, dehydrocholic acid, adamantane monocarboxylic acid, norbornane monocarboxylic acid, tricyclodecane monocarboxylic acid, or tetracyclodecane monocarboxylic acid) in a solvent such as tetrahydrofuran, and reacting the resultant with a polychloro compound represented by general formula (i-1) shown below in the presence of a catalyst such as triethylamine.

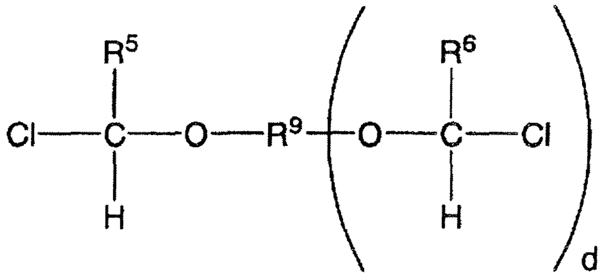

... (i - 1)

[wherein $R^5$, $R^6$, $R^9$ and d are as defined above for $R^5$, $R^6$, $R^9$ and d in formula (I-1) above.]

<Compound (II)>

Compound (II) is a compound represented by general formula (II) shown above.
In formula (II), $R^4$ is a monovalent organic group. Examples of such organic groups include the same as those exemplified above as the organic group as $R^2$ in formula (I) above.
The organic group as $R^4$ is preferably the same as $R^2$ in general formula (I) shown above. When $R^2$ and $R^4$ are the same, the decomposability of the compound (I) is improved.

In the decomposable composition of the present invention, the ratio of the amounts of the compounds (I) and (II) (weight ratio) is preferably compound (I):compound (II) = 100:1 to 100, more preferably 100:1 to 30, still more preferably 100:1 to 10.
When the amount of the compound (II) relative to 100 parts by weight of the compound (I) is 1 part by weight or more, the decomposability of the compound (I) is improved. On the other hand, when the amount of the compound (II) relative to 100 parts by weight of the compound (I) is 100 parts by weight or less, the dissolution contrast becomes satisfactory.

<Optional component>

The decomposable composition of the present invention may contain components other than the compounds (I) and (II), as long as the effects of the present invention are not impaired.
The other components may be arbitrarily selected from components formulated in materials (resists) conventionally used for forming films such as resist patterns.
As components formulated in materials (resists) conventionally used for forming films such as resist patterns, the following components may be exemplified.

[Acid generator which generates acid by irradiation of radial rays]

As an acid generator which generates acid by irradiation of radial rays, there is no particular limitation, and any acid generator proposed for use in chemically amplified resists can be used. Examples of these acid generators are numerous, and include onium salt-based acid generators such as iodonium salts and sulfonium salts; oxime sulfonate-based acid generators; diazomethane-based acid generators such as bisalkyl or bisaryl sulfonyl diazomethanes and poly(bis-sulfonyl)diazomethanes; nitrobenzylsulfonate-based acid generators; iminosulfonate-based acid generators; and disulfone-based acid generators.
The decomposable composition of the present invention preferably contains an acid generator. When the decomposable composition contains an acid generator, the acid generated by irradiation of radial rays, like the compound (II), decomposes the compound (I), thereby improving the decomposition efficiency of the compound (I).

[Nitrogen-containing organic compound]

As a nitrogen-containing organic compound, a multitude of compounds have already been proposed including cyclic amines and aliphatic amines, and any of these known compounds may be used.
Here, the term "aliphatic amine" refers to amines having one or more aliphatic groups, and the aliphatic group typically

has 1 to 12 carbons. Examples of these aliphatic amines include amines in which at least one hydrogen atom of ammonia $NH_3$ has been substituted with an alkyl group or hydroxyalkyl group of not more than 12 carbon atoms (i.e., alkylamines or alkyl alcohol amines). Specific examples of these aliphatic amines include monoalkylamines, dialkylamines, trialkylamines, and alkyl alcohol amines.
Examples of cyclic amines include heterocyclic compounds containing a nitrogen atom as a hetero atom. The heterocyclic compound may be monocyclic (aliphatic monocyclic amine) or polycyclic (aliphatic polycyclic amine).

<Organic solvent>

If desired, other miscible additives can also be added to a decomposable composition of the present invention. Examples of miscible additives include phosphorus oxo acids (e.g., phosphoric acid, phosphonic acid and phosphinic acid) or derivatives thereof; additive resins for improving the performance of the film formed by using the decomposable composition; surfactants for improving the ease of application; dissolution inhibitors; plasticizers; stabilizers; colorants; halation prevention agents; and dyes.

The decomposable composition of the present invention may be used by dissolving in an organic solvent (hereafter, frequently referred to as component (S)).
As the component (S), there is no particular limitation, and any solvent capable of dissolving each of the components used to generate a homogeneous solution is suitable. The solvent used can be one, or two or more solvents selected from amongst known solvents used for conventional chemically amplified resists.
Suitable examples include lactones such as γ-butyrolactone; ketones such as acetone, methyl ethyl ketone, cyclohexanone, methyl n-amyl ketone, methyl isoamyl ketone and 2-heptanone; polyhydric alcohols such as ethylene glycol, diethylene glycol, propylene glycol, or dipropylene glycol; compounds having an ester linkage, such as ethylene glycol monoacetate, diethylene glycol monoacetate, propylene glycol monoacetate, or dipropylene glycol monoacetate; derivatives of polyhydric alcohols, such as compounds having an ether linkage including monoalkyl ethers (e.g., monomethyl ethers, monoethylethers, monopropyl ethers and monobutyl ethers) and monophenyl ethers of the above-mentioned polyhydric alcohols or the above-mentioned compounds having an ester linkage (of these, propylene glycol monomethyl ether acetate (PGMEA) and propylene glycol monomethyl ether (PGME) are preferable); cyclic ethers such as dioxane; esters such as methyl lactate, ethyl lactate (EL), methyl acetate, ethyl acetate, butyl acetate, methyl pyruvate, ethyl pyruvate, methyl methoxypropionate and ethyl ethoxypropionate; and aromatic compounds such as anisole, ethyl benzyl ether, cresyl methyl ether, diphenyl ether, dibenzyl ether, phenetole, butyl phenyl ether, ethylbenzene, diethylbenzene, amylbenzene, isopropylbenzene, toluene, xylene, cymene and mesitylene.
These organic solvents may be used either alone, or as a mixed solvent of two or more different solvents.
Among these, propylene glycol monomethyl ether acetate (PGMEA), propylene glycol monomethyl ether (PGME) and ethyl lactate (EL) are preferable.
Further, a mixed solvent formed by mixing propylene glycol monomethyl ether acetate (PGMEA) and a polar solvent is preferred, and the mixing ratio (weight ratio) can be determined on the basis of the compatibility of the PGMEA and the polar solvent, but is preferably within a range from 1:9 to 9:1, more preferably from 2:8 to 8:2.
More specifically, when EL is mixed as a polar solvent, the PGMEA:EL weight ratio is preferably within a range from 1:9 to 9:1, more preferably from 2:8 to 8:2. Alternatively, when PGME is mixed as a polar solvent, the PGMEA:PGME weight ratio is preferably within a range from 1:9 to 9:1, more preferably from 2:8 to 8:2, still more preferably 3:7 to 7:3.
In addition, as the component (S), a mixed solvent of at least one of PGMEA and EL, together with γ-butyrolactone is also preferred. In such cases, the mixing ratio is set so that the weight ratio between the former and latter components is preferably within a range from 70:30 to 95:5.
There is no particular limitation on the amount of the component (S) used. For example, when the decomposable composition of the present invention is used for forming a film in a manner as described below in the method for using the decomposable composition of the present invention, the amount of the organic solvent is appropriately set depending on the concentration at which a solution of the decomposable composition can be applied to a substrate, and the desired coating film thickness.
In the present invention, the organic solvent is preferably used in an amount such that the solid fraction content of the total of the compounds (I) and (II) becomes within the range of 3 to 50% by weight, more preferably within the range of 5 to 30% by weight.

«Method for using a decomposable composition»

The method for using a decomposable composition of the present invention includes the steps of: forming a film on a substrate by using a decomposable composition of the present invention; reacting the compound (I) with the compound (II) in the film to form a compound (III) represented by general formula (III) shown below from the compound (I); and decomposing the compound (I) with the compound (III) :

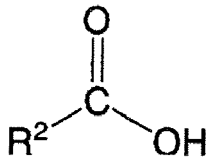

... (I I I)

[wherein $R^2$ is as defined for $R^2$ in general formula (I) above.]

Specifically, the method of the present invention can be performed, for example, as follows.

Firstly, a decomposable composition of the present invention is applied to a substrate such as a silicon wafer using a spinner or the like, and baking is conducted to form a film (hereafter, frequently referred to as "decomposable film"). An organic or inorganic anti-reflective film may be provided between the substrate and the decomposable film to form a double-layer laminate. Alternatively, an organic anti-reflective film may be provided on the decomposable film to form a double-layer laminate, or an anti-reflection film constituting a lower layer (i.e., anti-reflective film provided between the substrate and the decomposable film) may be further provided to form a triple-layer laminate. The anti-reflective film provided on the decomposable film is preferably soluble to an alkali developing solution.

The steps described above can be performed by any conventional methods known in the fields of lithography or the like. The operation conditions such as baking conditions (temperature, time, etc.) can be appropriately selected depending on the constitution and properties of the decomposable composition.

Subsequently, the compound (I) is reacted with compound (II) in the film to form a compound (III), and the compound (I) is decomposed by the compound (III).

As described in connection with the decomposable composition of the present invention, when the compound (I) is reacted with the compound (II), at least the linkage between the oxygen atom bonded to the carbon atom within the carbonyl group adjacent to $R^2$ and the carbon atom to which the oxygen atom is bonded (i.e., carbon atom having $R^1$ bonded thereto) is broken to form a compound (III).

The compound (III), like the compound (II), exhibits the action of decomposing the compound (I). Thus, by the formation of the compound (III), the decomposition efficiency of the compound (I) is improved.

More specifically, in the decomposable composition, firstly, when the decomposition of the compound (I) is started by the compound (II), the compound (III) is formed, and the compound (III), like the compound (II), decomposes the compound (I). As the decomposition of the compound (I) proceeds and the amount of the compound (I) decreases, the amount of carboxylic acids in the decomposable composition (i.e., the compounds (II) and (III)) increases. As a result, the decomposition efficiency of the compound (I) is improved.

It is presumed that, in the decomposable composition, decomposition of the compound (I) (formation of compound (III)) by the reaction between the compound (I) and the compound (II) and the decomposition of the compound (I) by the compound (III) proceed simultaneously.

The reaction between the compound (I) and the compound (II) can be effected by externally applying energy such as heat, radiation or ion beam to the decomposable film. For example, the reaction between the compound (I) and the compound (II) can be effected by heating a part or all of the decomposable film. Further, the reaction between the compound (I) and the compound (III) can be effected in the same manner as in the reaction between the compound (I) and the compound (II).

Examples of methods for heating the decomposable film include a method in which the decomposable film or the substrate on which the decomposable film is formed is directly heated using a hot plate, an oven or the like; and a method in which heating is conducted by local irradiation of radial rays. A specific example of a method using radial rays includes a method in which laser beam is focused to perform spot irradiation, thereby heating the film to a temperature of 200 to 600°C. With respect to the radial rays, there is no particular limitation, and any radial rays typically used in photolithography can be used. Examples of radial rays include visible light rays, semiconductor lasers (405 nm), g-line radiation, h-line radiation, i-line radiation, ArF excimer lasers, KrF excimer lasers, $F_2$ excimer lasers, extreme ultraviolet (EUV) rays, vacuum ultraviolet (VUV) rays, electron beam (EB), x-rays and soft x-rays.

<Deprotection ratio>

In the decomposable composition and the method for using the same according to the present invention, whether or not the compound (I) has decomposed, and the degree of decomposition of the compound (I) can be evaluated by analyzing the deprotection ratio.

Here, the term "deprotection ratio" means the percentage (%), based on the amount of acetal structure (-CO-O-CH(-R)-O-) derived from the compound (I) contained in the decomposable composition prior to decomposition, of the amount of the acetal structure contained in the decomposable composition following decomposition.
As mentioned above, in the decomposition of the compound (I), at least the linkage between the oxygen atom bonded to the carbon atom of the carbonyl group within the acetal structure and the carbon atom to which the oxygen atom is bonded (i.e., carbon atom having R bonded thereto) is broken. When this linkage is broken, by a $^1$H-NMR analysis, a change is observed in the chemical shift ascribed to the hydrogen atom bonded to the carbon atom having R bonded thereto within the acetal structure (hereafter, this hydrogen atom is referred to as "acetal proton").
On the other hand, in the compound (I), the structure of a group bonded to the acetal structure (e.g., $R^2$) does not change, and thus, a chemical shift ascribed to a proton derived from $R^2$ does not change.
Accordingly, with respect to each of the decomposable composition prior to decomposition and the decomposable composition following decomposition, by determining the "peak area of the acetal proton" in terms of percentage based on the peak area of a specific proton (standard proton) selected from protons derived from $R^2$, the deprotection ratio (%) can be calculated from the following formula:

$$\text{Deprotection ratio (\%)} = [(\text{Value A prior to decomposition - value A following decomposition}) / \text{value A prior to decomposition}] \times 100$$

When the compound (I) is decomposed, the amount of the compound (I) in the decomposable composition decreases, while acidic compounds such as $R^2$-COOH are formed as decomposition products, so that the properties (e.g. alkali solubility) of the decomposable composition are changed.
Specifically, for example, in a decomposable film obtained in a manner as described above, the portion where a part or all of the compound (I) has decomposed exhibits an increased alkali solubility, as compared to the state prior to decomposition. For example, by selectively heating a part of the decomposable film, difference in alkali solubility (dissolution contrast) is generated between the heated portion and the non-heated portion. Therefore, by selectively heating the decomposable film, followed by developing with a developing solution such as an aqueous alkali solution, a pattern in which the decomposable film has been patterned into a desired form can be obtained.
In the decomposable composition and the method for using the same according to the present invention, the decomposition of the compound (I) is effected not only by the compound (II) which is initially formulated, but also by the compound (III) which is generated from the compound (I). That is, in the decomposition of the decomposable composition of the present invention, a self-decomposition mechanism is working in which the compound (compound (III)) generated by the decomposition of the compound (I) itself further decomposes itself.
Further, in the decomposable composition and the method for using the same according to the present invention, the compound (II) catalytically decomposes the compound (I), and by the decomposition, compound (III) is generated which, like the compound (II), exhibits the action of decomposing the compound (I). That is, in the decomposable composition of the present invention, as the decomposition proceeds, the amount of acids which exhibit the action of decomposing the compound (I) (i.e., total amount of compound (II) and compound (III)) increases, so that the decomposition efficiency of the compound (I) is enhanced. Therefore, by applying the decomposable composition of the present invention to a chemically amplified resist composition which is conventionally known as a resist material exhibiting high sensitivity, the sensitivity of the chemically amplified resist composition can be further improved.
Specifically, by adding an acid generator used in a chemically amplified resist composition to the decomposable composition of the present invention, forming a film (resist film) using the resulting decomposable composition, conducting exposure, and optionally baking the resist film following exposure, acid is generated from the acid generator which, like the compound (II), decomposes the compound (I) as a base component. Here, the decomposition of the compound (I) proceeds not only by the action of the acid generated from the acid generator, but also by the action of the compounds (II) and (III) and the like, so that the decomposition efficiency of the decomposable composition becomes superior to that of a typical chemically amplified resist composition. As a result, the sensitivity of a chemically amplified resist composition can be improved.
As an example of a preferable field of application for the decomposable composition of the present invention, thermal lithography can be mentioned.
Thermal lithography, as described for example in the above-mentioned Non-Patent Documents 2 and 3, is a technique in which a film is formed by using a material exhibiting changed alkali solubility under action of heat, followed by selective heating of the film to form fine patterns. The above-mentioned non-patent documents describe that by heating a film by using a laser beam of 365 nm or a semiconductor laser beam (405 nm), a pattern can be formed with a resolution higher than the critical resolution achieved by typical photolithography using a laser beam of 365 nm or a semiconductor laser

beam. The decomposable composition of the present invention can be applied to such thermal lithography.

[Examples]

As follows is a description of examples of the present invention, although the scope of the present invention is by no way limited by these examples.
The respective structures of compounds as raw materials used in the following Synthesis Examples 1 to 4 are shown below.
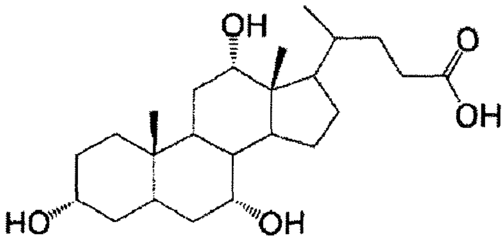

Cholic acid

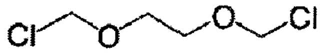

1,2-bis(chloromethoxy)ethane

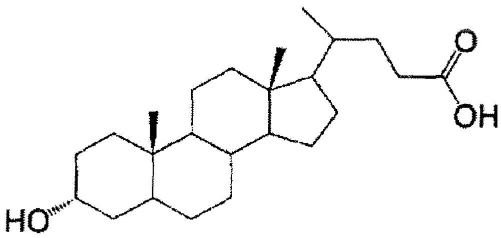

Lithocholic acid

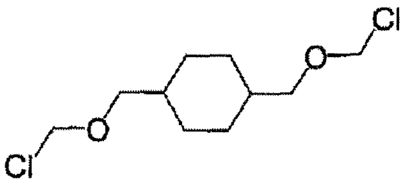

1,4-bis(chloromethoxy)cyclohexane

Synthesis Example 1 (synthesis of compound (1) (a cholate ester))

6 g of cholic acid was dissolved in 50 g of tetrahydrofuran, and 3.04 g of triethylamine was added thereto and stirred for 10 minutes. Then, 1.17 g of 1,2-bis(chloromethoxy)ethane was added to the resultant and stirred for 10 hours at room temperature. Following the completion of the reaction, the product was extracted using a water/ethyl acetate system. Then, the ethyl acetate solution was dried with sodium sulfate, followed by concentration under reduced pressure, thereby obtaining 3.5 g of a compound (1) represented by formula (1) shown below.
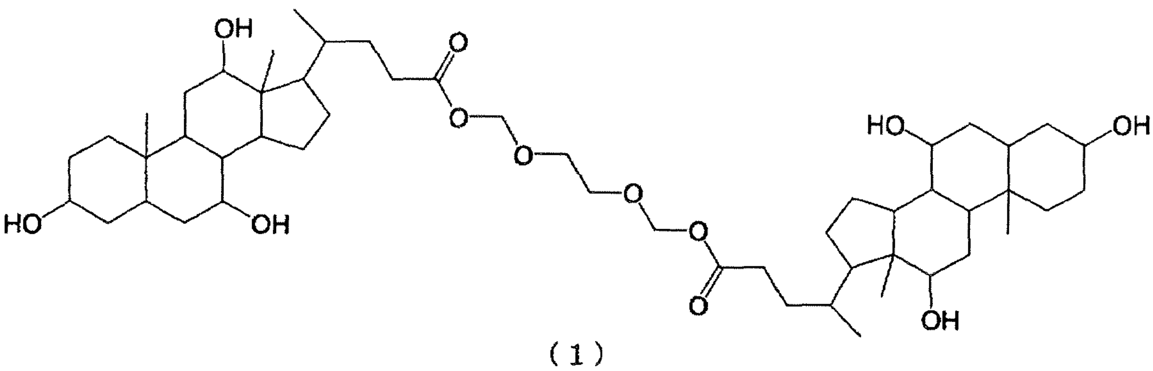

(1)

[Identification of compound (1)]

$^1$H-NMR (deuterated DMSO, internal standard: tetramethylsilane): δ5.21 s 4H, 4.26-4.31 m 2H, 4.07-4.11 m 2H, 3.96-3.99 m 2H, 3.74-3.81 m 2H, 3.71 s 4H, 3.57-3.64 m 2H, 3.13-3.24 m 2H, 2.31-2.72 m 2H, 2.06-2.31 m 6H, 1.93-2.04 m 2H, 1.58-1.85 m 12H, 1.11-1.51 m 22H, 0.78-1.03 m 16H, 0.60 s 6H
IR ($cm^{-1}$): 3410, 2937, 2869,1740
Further, Tg (glass transition temperature) was 177°C. In the synthesis examples, Tg is a value as measured by a thermal analyzer TG/DTA6200 (manufactured by Seiko Instrumental) under a temperature elevation condition of 10°C/min.

Synthesis Example 2 (synthesis of compound (2) (a cholate ester))

8 g of cholic acid was dissolved in 60 g of tetrahydrofuran, and 3.04 g of triethylamine was added thereto and stirred for 10 minutes. Then, 2.36 g of 1,4-bis(chloromethoxy)cyclohexane was added to the resultant and stirred for 10 hours at room temperature. Following the completion of the reaction, the product was extracted using a water/ethyl acetate system. Then, the ethyl acetate solution was dried with sodium sulfate, followed by concentration under reduced pressure, thereby obtaining 5.0 g of a compound (2) represented by formula (2) shown below.
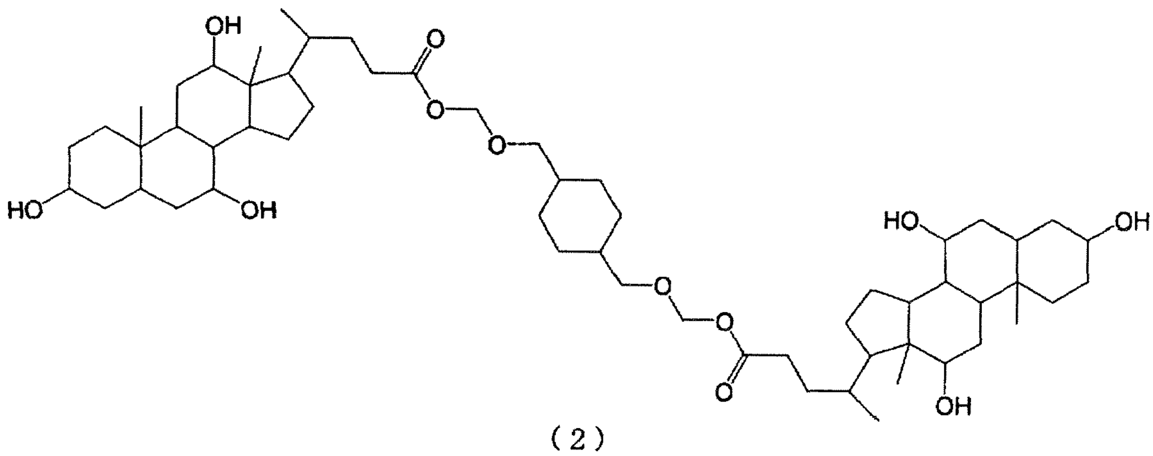

(2)

[Identification of compound (2)]

$^1$H-NMR (deuterated DMSO, internal standard: tetramethylsilane): δ5.19 s 4H, 4.27-4.29 m 2H, 4.08-4.10 m 2H, 3.96-3.98 m 2H, 3.76-3.80 m 2H, 3.59-3.63 m 2H, 3.36-3.40 m 4H, 3.13-3.23 m 2H, 2.29-2.40 m 2H, 2.10-2.29 m 6H, 1.92-2.06 m 2H, 1.58-1.87 m 14H, 1.07-1.52 m 30H, 0.77-1.03 m 16H, 0.58 s 6H
IR ($cm^{-1}$): 3413, 2934, 2867, 1740
Further, Tg was 100°C.

Synthesis Example 3 (synthesis of compound (3) (a lithocholate ester))

6 g of lithocholic acid was dissolved in 50 g oftetrahydrofuran, and 3.04 g of triethylamine was added thereto and stirred for 10 minutes. Then, 1.27 g of 1,2-bis(chloromethoxy)ethane was added to the resultant and stirred for 10 hours at room temperature. Following the completion of the reaction, the product was extracted using a water/ethyl acetate system. Then, the ethyl acetate solution was dried with sodium sulfate, followed by concentration under reduced pressure, thereby obtaining 6.5 g of a compound (3) represented by formula (3) shown below.
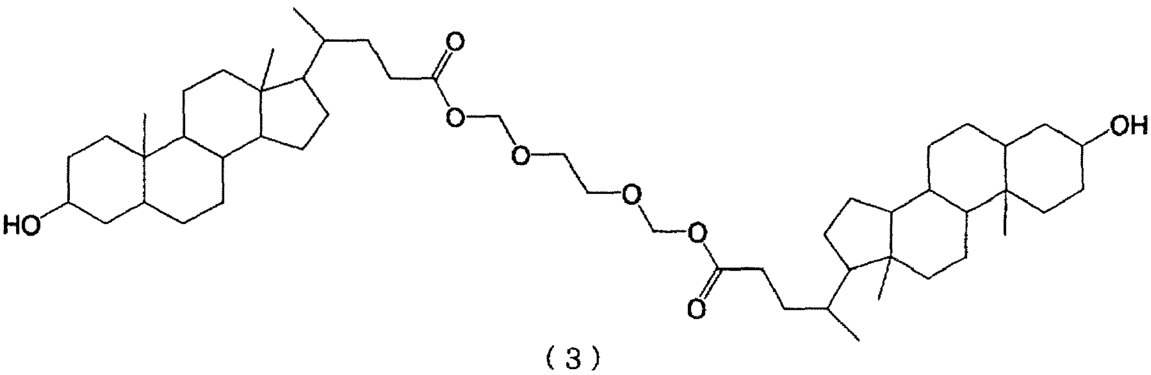

(3)

[Identification of compound (3)]

$^1$H-NMR (deuterated DMSO, internal standard: tetramethylsilane): δ5.21 s 4H, 4.36-4.47 m 2H, 3.69 s 4H, 3.24-3.42 m 2H, 2.30-2.41 m 2H, 2.18-2.23 m 2H, 1.88-1.95 m 2H, 1.45-1.86 m 14H, 0.95-1.43 m 32H, 0.84-0.95 m 16H, 0.61 s 6H
IR ($cm^{-1}$): 3400, 2935, 2865, 1743
Further, Tg was 151 °C.

Synthesis Example 4 (synthesis of compound (4) (a lithocholate ester))

8 g of lithocholic acid was dissolved in 60 g of tetrahydrofuran, and 3.04 g of triethylamine was added thereto and stirred for 10 minutes. Then, 2.56 g of 1,4-bis(chloromethoxy)cyclohexane was added to the resultant and stirred for 10 hours at room temperature. Following the completion of the reaction, the product was extracted using a water/ethyl acetate system. Then, the ethyl acetate solution was dried with sodium sulfate, followed by concentration under reduced pressure, thereby obtaining 8.2 g of a compound (4) represented by formula (4) shown below.
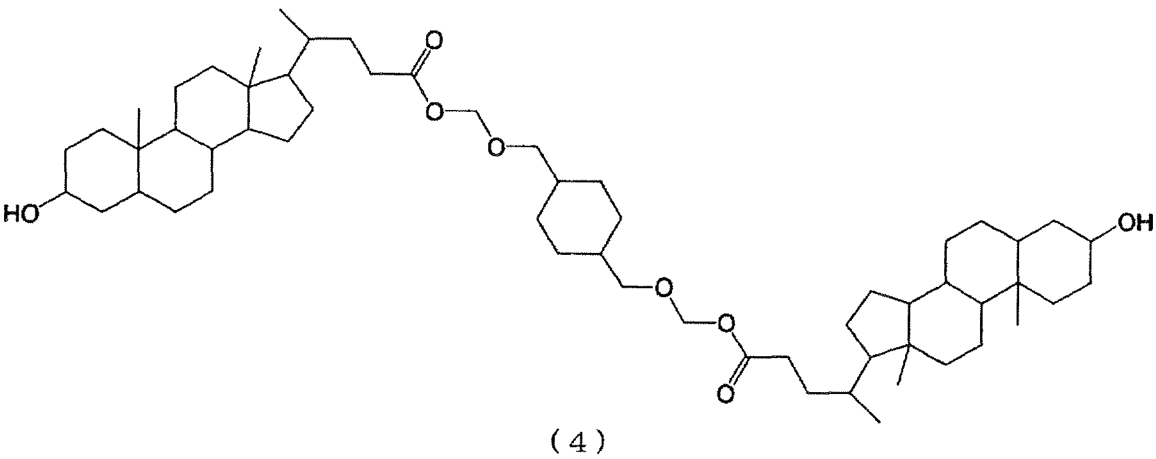

(4)

[Identification of compound (4)]

$^1$H-NMR (deuterated DMSO, internal standard: tetramethylsilane): 85.19 s 4H, 4.33-4.49 m 2H, 3.18-3.43 m 6H, 2.28-2.39 m 2H, 2.16-2.28 m 2H, 1.88-1.96 m 2H, 0.97-1.88 m 56H, 0.80-0.96 m 16H, 0.60 s 6H
IR ($cm^{-1}$) : 3400, 2935, 2865, 1743
Further, Tg was 144°C.

Test Example 1 (reaction within an aqueous suspension)

100 Parts by weight of the compound (1), 100 parts by weight of cholic acid and 3,300 parts by weight of water were mixed together in a flask to obtain a decomposable composition 1 (an aqueous suspension of a decomposable composition). With respect to the obtained decomposable composition 1 (decomposable composition 1 prior to decomposition), $^1$H-NMR (400 MHz) analysis was conducted.

Subsequently, the decomposable composition 1 was stirred under the conditions indicated in Table 1 shown below. In Table 1, room temperature is 23°C.

With respect to the decomposable composition 1 following stirring (i.e., the decomposable composition following decomposition), $^1$H-NMR analysis was conducted under the same condition as described above.

From the results of the $^1$H-NMR analysis, the deprotection ratio (%) was calculated by the formula shown below. The results are shown in Table 1.

$$\text{Deprotection ratio (\%)} = [(\text{Value A prior to decomposition - value A following decomposition}) / \text{value A prior to decomposition}] \times 100$$

In the formula above, the value A is the peak area ascribed to hydrogen atoms (2 x 2 acetal protons) within methylene groups which have bonded thereto the oxygen atom (-O-) within the carbonyloxy group, in terms of percentage based on the peak area around 0.6 ppm, which is ascribed to hydrogen atoms (2 x 3 atoms) within the methyl groups bonded to the carbon atoms at positions 10 and 13 of the perhydrocyclopentaphenanthrene ring within the compound (1).

Namely, since the peak around 0.6 ppm is ascribed to the hydrogen atoms within the methyl groups bonded to the perhydrocyclopentaphenanthrene ring within the decomposable composition 1, the peak is constant, regardless of whether or not the decomposable composition has been decomposed. On the other hand, the peak area ascribed to the acetal protons becomes smaller as the amount of the decomposable composition decomposed becomes larger. Thus, by calculating the peak areas ascribed to the acetal protons prior to and following the stirring, based on the peak area around 0.6 ppm as a standard, the deprotection ratio can be calculated from the formula shown above.

With respect to the decomposable composition 1, the actual values were as follows. The value A prior to decomposition was 31.66, the value A following decomposition at room temperature for 10 hours was 28.44, and the value A following decomposition at 100°C for 3 hours was 19.96.

Accordingly, the deprotection ratio under reaction conditions wherein the decomposition was conducted at room temperature for 10 hours was [(31.66 - 28.44)/31.66] x 100 = 10.17%, and the deprotection ratio under reaction conditions wherein the decomposition was conducted at 100°C for 3 hours was [(31.66 - 19.96)/31.66] x 100 = 36.96%.

[Table 1]

| | Stirring conditions | Deprotection ratio |
|---|---|---|
| Decomposable composition 1 | Room temperature, 10 hours | 10.17% |
| | 100°C, 3 hours | 36.96% |

Test Example 2 (reaction within a film)

Decomposable compositions 2 to 4 (propylene glycol monomethyl ether (PGME) solutions of decomposable compositions) were produced by mixing and dissolving together the materials indicated in Table 2 shown below.

[Table 2]

| | Formulation | | |
|---|---|---|---|
| Decomposable composition 2 | Compound (1) [100] | Cholic acid [100] | PGME [1800] |
| Decomposable composition 3 | Compound (3) [100] | Lithocholic acid | PGME [1800] |
| Decomposable composition 4 | Compound (4) [100] | Lithocholic acid | PGME [1800] |

Each of the decomposable compositions was applied onto a silicon wafer having a diameter of 8 inches using a spinner, and baking was conducted on a hot plate under baking conditions at 100°C for 3 minutes to dry the decomposable composition, thereby forming a film having a thickness of 200 nm. The formed film was visually observed, and was found to be transparent, which meant that an amorphous film was formed. Further, a portion of the film was cut out, and $^1$H-NMR analysis was conducted with respect to the portion cut out under the same conditions as described above.

Subsequently, using the decomposable compositions 2 to 4, films were formed in the same manner as described above, and each of the films was subjected to heat treatment (deprotection treatment) under baking conditions at 100°C for 3 minutes or at 100°C for 10 minutes.

With respect to the films which have been subjected to deprotection treatment, $^1$H-NMR analysis was conducted under the same conditions as described above.

From the results of the $^1$H-NMR analysis, the deprotection ratio (%) was calculated in substantially the same manner as in Test Example 1, except that the value A prior to deprotection treatment was used as the value A prior to decomposition, and the value A following deprotection treatment was used as the value A following decomposition. The values A prior to and following deprotection treatment and the deprotection ratios are indicated in Table 3 shown below.

[Table 3]

| | Baking conditions | Value A prior to deprotection to treatment | Value A following deprotection treatment | Deprotection ratio |
|---|---|---|---|---|
| Decomposable composition 2 | 100°C, 3 minutes | 31.66 | 30.50 | 3.66% |
| | 100°C, 10 minutes | 31.66 | 30.31 | 4.26% |
| Decomposable composition 3 | 100°C, 3 minutes | 31.53 | 29.61 | 6.09% |
| Decomposable composition 4 | 100°C, 3 minutes | 29.98 | 26.59 | 11.31% |

Test Example 3 (Change in dissolution rate within alkali)

Decomposable compositions 5 to 11 (PGME solutions of decomposable compositions) were produced by mixing and dissolving together the materials indicated in Table 4 shown below.

[Table 4]

| | Formulation | | |
|---|---|---|---|
| Decomposable composition 5 | Compound (1) [100] | Cholic acid [5] | PGME [1000] |
| Decomposable composition 6 | Compound (2) [100] | Cholic acid [5] | PGME [1000] |
| Decomposable composition 7 | Compound (4) [100] | Lithocholic acid [5] | PGME [1000] |
| Decomposable composition 8 | Compound (1) [100] | - | PGME [1000] |
| Decomposable composition 9 | Compound (2) [100] | - | PGME [1000] |
| Decomposable composition 10 | Compound (3) [100] | - | PGME [1000] |
| Decomposable composition 11 | Compound (4) [100] | | PGME [1000] |

Each of the PGME solutions of the decomposable compositions was applied onto a silicon wafer having a diameter of 8 inches using a spinner, and baking was conducted on a hot plate under baking conditions at 90°C for 1.5 minutes to dry the decomposable composition, thereby forming a film having a film thickness of 200 nm. Then, the obtained film was immersed in a 2.38% by weight aqueous solution of tetramethylammonium hydroxide (TMAH) at 23°C for 60 seconds. Following the immersion, the film thickness was measured. From the difference between the film thickness prior to the immersion and the film thickness following the immersion, the dissolution rate (Å/sec) of the film following the baking at 90°C for 1.5 minutes was determined.

Subsequently, using the decomposable compositions 5 to 11, films were formed in the same manner as described

above, and each of the films was subjected to baking at 100°C for 3 minutes. Then, with respect to each of the films, the dissolution rate (the dissolution rate of the film following baking at 100°C for 3 minutes) was determined in the same manner as described above.

The results are shown in Table 5 below.

As shown in Table 5, a comparison between the dissolution rate of the film following the baking at 90°C for 1.5 minutes and the dissolution rate of the film following baking at 100°C for 3 minutes reveals that the dissolution rate of the film following baking at 100°C for 3 minutes with respect to the decomposable compositions 5 to 7 is larger. Accordingly, it was confirmed that the alkali solubility of the film was increased by the baking at 100°C for 3 minutes. The reason for this is presumed to be because the compound (1), (2) or (4) within the film gets decomposed by the baking at 100°C for 3 minutes. On the other hand, with respect to the decomposable compositions 8 to 11 which contain no cholic acid or lithocholic acid corresponding to the compound (II), the alkali solubility was not changed by the same treatment as described above.

[Table 5]

| | Dissolution rate of film (Å/sec) | |
|---|---|---|
| | Following baking at 90°C for 1.5 min | Following baking at 100°C for 3 min |
| Decomposable composition 5 | 0.3 | 1.7 |
| Decomposable composition 6 | 0.3 | 1.2 |
| Decomposable composition 7 | 0.3 | 3.8 |

From the results shown above, it is apparent that the compound (I) has been decomposed in the decomposable compositions containing either one of compounds (1) to (4) which corresponds to the compound (I), and cholic acid or lithocholic acid which corresponds to the compound (II).

Further, in the decomposable compositions 1 to 7, compound (III) is formed by decomposing the compound (I), wherein both of the compounds (II) and (III) are cholic acid or lithocholic acid, meaning that the compound (II) proliferates cholic acid or lithocholic acid which is the same as the compound (II) itself.

Thus, it is presumed that in the decomposable compositions, the decomposition of the compound (I) is effected not only by the compound (II) which is initially formulated, but also by cholic acid or lithocholic acid (i.e., compound (III)) which is formed by the decomposition. That is, in the decomposition of the decomposable composition of the present invention, a self-decomposition mechanism is working in which the compound (compound (III)) generated by the decomposition of the compound (I) itself further decomposes itself.

INDUSTRIAL APPLICABILITY

The decomposable composition of the present invention can be applied to a chemically amplified resist composition which is conventionally known as a resist material exhibiting high sensitivity, to further improve the sensitivity of the chemically amplified resist composition. Further, the decomposable composition of the present invention can be applied to, for example, thermal lithography. Therefore, the present invention is extremely useful in industry.

## Claims

**1.** A decomposable composition comprising a compound (I) represented by general formula (I) shown below and a compound (II) represented by general formula (II) shown below:

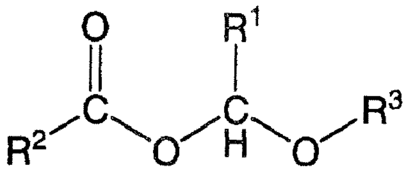 ··· (I)

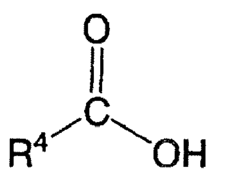 ··· (II)

[wherein $R^1$ represents a hydrogen atom, a halogen atom, an alkyl group or a halogenated alkyl group; and $R^2$, $R^3$ and $R^4$ each independently represents a monovalent organic group.]

**2.** The decomposable composition according to claim 1, wherein said compound (I) is a non-polymer having a molecular weight of 500 to 3,000.

**3.** The decomposable composition according to claim 2, wherein said compound (I) is represented by general formula (I-1) shown below:

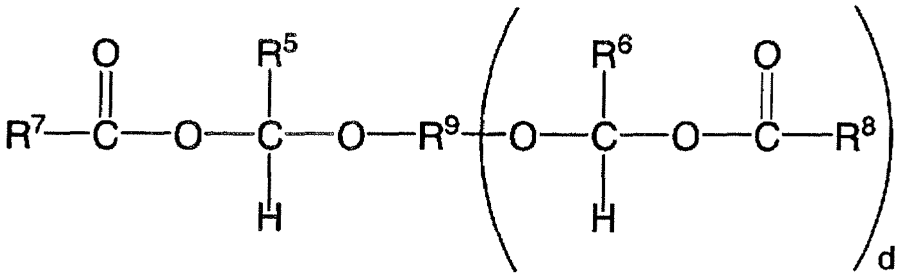

··· (I − 1)

[wherein $R^5$ and $R^6$ each independently represents a hydrogen atom, a halogen atom, an alkyl group or a halogenated alkyl group; $R^7$ and $R^8$ each independently represents a cyclic group-containing group; $R^9$ represents an organic group having a valency of (d + 1); and d represents an integer of 1 to 3.]

**4.** The decomposable composition according to claim 3, wherein the cyclic group of each of $R^7$ and $R^8$ in general formula (I-1) is an aliphatic polycyclic group.

**5.** The decomposable composition according to claim 4, wherein the cyclic group of each of $R^7$ and $R^8$ in general formula (I-1) is a group having a perhydrocyclopentaphenanthrene ring as a basic skeleton.

**6.** The decomposable composition according to claim 1, wherein $R^4$ in general formula (II) is a cyclic group-containing group.

**7.** The decomposable composition according to claim 6, wherein $R^4$ in general formula (II) is an aliphatic polycyclic group.

**8.** The decomposable composition according to claim 7, wherein $R^4$ in general formula (II) is a group having a perhydrocyclopentaphenanthrene ring as a basic skeleton.

**9.** Method for using a decomposable composition of any one of claims 1 to 8, comprising the steps of:

forming a film on a substrate by using a decomposable composition of any one of claims 1 to 8;
reacting said compound (I) with said compound (II) in the film to form a compound (III) represented by general formula (III) shown below from said compound (I); and
decomposing said compound (I) with said compound (III):

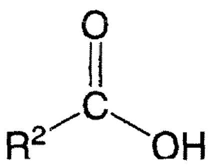

··· (III)

[wherein $R^2$ is as defined for $R^2$ in general formula (I) above.]

European Patent Office

# EUROPEAN SEARCH REPORT

Application Number
EP 07 10 7637

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP 2000 010285 A (FUJI PHOTO FILM CO LTD) 14 January 2000 (2000-01-14) * page 122; example 6; table 1 * | 1,2,9 | INV. G03F7/004 G03F7/039 |
| X<br>Y | US 2002/022197 A1 (M.H. JUNG ET AL.) 21 February 2002 (2002-02-21)<br>* page 5; example 10 * | 1,2,9<br>4-8 | |
| Y | EP 1 126 320 A (KOREA KUMHO PETROCHEMICAL CO., LTD.) 22 August 2001 (2001-08-22) * pages 14-15 * | 4-8 | |
| X | JP 09 265177 A (NIPPON ELECTRIC CO) 7 October 1997 (1997-10-07) * page 6, paragraph 38 * * page 7, paragraph 43 - paragraph 48 * | 1,9 | |
| X | US 5 532 106 A (J.M.J. FRECHET ET AL.) 2 July 1996 (1996-07-02) * claims 1,5 * | 1,9 | TECHNICAL FIELDS SEARCHED (IPC)<br>G03F |

The present search report has been drawn up for all claims

| Place of search | Date of completion of the search | Examiner |
|---|---|---|
| The Hague | 9 October 2007 | Dupart, Jean-Marc |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

2

## ANNEX TO THE EUROPEAN SEARCH REPORT ON EUROPEAN PATENT APPLICATION NO. EP 07 10 7637

This annex lists the patent family members relating to the patent documents cited in the above-mentioned European search report.
The members are as contained in the European Patent Office EDP file on
The European Patent Office is in no way liable for these particulars which are merely given for the purpose of information.

09-10-2007

| Patent document cited in search report | Publication date | Patent family member(s) | Publication date |
|---|---|---|---|
| JP 2000010285 A | 14-01-2000 | NONE | |
| US 2002022197 A1 | 21-02-2002 | JP 2002040635 A | 06-02-2002 |
| | | KR 20010012765 A | 22-12-2001 |
| | | TW 583502 B | 11-04-2004 |
| EP 1126320 A | 22-08-2001 | JP 3477163 B2 | 10-12-2003 |
| | | JP 2001228613 A | 24-08-2001 |
| | | KR 20010083547 A | 01-09-2001 |
| | | TW 224717 B | 01-12-2004 |
| | | US 2001041302 A1 | 15-11-2001 |
| JP 9265177 A | 07-10-1997 | JP 3006475 B2 | 07-02-2000 |
| US 5532106 A | 02-07-1996 | US 5585223 A | 17-12-1996 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2006148173 A
- JP 2881969 B
- JP 2003241385 A


### Non-patent literature cited in the description


- *J. Am. Chem. Soc.,* 1998, vol. 120, 37-45
- *Jpn. J. Appl. Phys.,* 2004, vol. 43 (8B), L1045-L1047
- *Jpn. J. Appl. Phys.,* 2002, vol. 41 (9A/B), L1022-L1024